# EUROPEAN PATENT APPLICATION

(11) **EP 4 625 489 A1**
(43) Date of publication of application: **01.10.2025**
(21) Application number: 25165469.5
(22) Date of filing: 21.03.2025
(51) Int. Cl.: H01L 23/427, H05K 7/20, H01L 23/473, H05K 1/02, G06F 1/20, H01L 23/367

(54) **SERVICEABLE THERMAL INTERCONNECT**

(30) Priority: 29.03.2024 US 202463571577 P; 10.05.2024 US 202418660991
(71) Applicant: Microsoft Technology Licensing, LLC, Redmond, WA 98052 (US)
(72) Inventor: FARIAS MOGUEL, Oscar, Redmond, 98052 (US); ANTONY, Christy Felix Pradeep, Redmond, 98052 (US); TRIEU, Dennis, Redmond, 98052 (US)
(74) Representative: CMS Cameron McKenna Nabarro Olswang LLP

(57) **Abstract**

Hot-swappable electronic components may be incompatible with traditional cold plates as additional operations are required to detach the hot-swappable electronic components. Such activities risk a coolant leak and thus tend to require an entire associated system to be powered down for component replacement. This is inefficient and undesirable as it causes unnecessary downtime. The presently disclosed thermal interconnect allows for such replacements with little to no risk of coolant leaks, and thus no requirement to power down the entire system. Still further, the presently disclosed thermal interconnect may allow for more electronic components to be connected to a main cooling loop within the overall system, thereby yielding server architectures with increased density and higher processing power. The thermal interconnect is a selectively connectable fixture that mates a series of alternating parallel structures together. Thermal energy captured by the vapor chamber(s) is rejected into the liquid coolant via the thermal interconnect.

## Description

### Background

A printed circuit board (PCB) mechanically supports and electrically interconnects an array of electronic components using conductive traces, vias, and other features etched from metallic sheets laminated onto a non-conductive substrate. Typically, the PCB is a laminated sandwich structure of conductive and insulating layers. Each of the conductive layers includes an artwork pattern of traces, planes, and other features etched from one or more sheet layers of copper laminated onto and/or between the insulating layers.

### Summary

Implementations described and claimed herein address the problems described herein by providing a thermal interconnect comprising a first thermal connector and a second thermal connector. The first thermal connector includes a first array of spaced structures extending linearly outward in parallel and is contiguous with a heat-transfer device. The heat-transfer device is in thermally conductive contact with a heat-generating component. The second thermal connector includes a second array of spaced structures extending linearly outward in parallel and including fluid cavities therein. The second thermal connector is in fluidic communication with a cooling loop including a liquid coolant. The second thermal connector selectively connects to the first thermal connector by interlacing the first array of spaced structures with the second array of spaced structures.

Other implementations are also described and recited herein.

### Brief Description of the Drawings

FIG. 1 illustrates a heat-generating component mounted on a printed circuit board (PCB) and cooled via a heat pipe connected to an external cooling system using an example thermal interconnect according to the presently disclosed technology.
FIG. 2 illustrates an example thermal interconnect according to the presently disclosed technology.
FIG. 3 illustrates a field-programmable gate array (FPGA) mounted on a PCB and cooled via a vapor chamber connected to a cooling loop using an example thermal interconnect according to the presently disclosed technology.
FIG. 4 illustrates a dual in-line memory module (DIMM) cooled via a vapor chamber connected to a cooling loop using example thermal interconnects according to the presently disclosed technology.
FIG. 5 illustrates a solid-state drive (SSD) cooled via a vapor chamber connected to a cooling loop using an example thermal interconnect according to the presently disclosed technology.
FIG. 6 illustrates heat-generating components mounted on opposing sides of a PCB and cooled via a vapor chamber and a cold plate connected across the PCB using example thermal interconnects according to the presently disclosed technology.
FIG. 7 illustrates example operations for using a thermal interconnect to reject thermal energy from a computing device.

### Detailed Description

Printed circuit boards (PCBs) are a fundamental component used in nearly all electronics. PCB substrates provide electrical connections and mechanical support to electronic components and are generally made of copper layers laminated onto, through, and/or between one or more non-conductive substrate layers. The copper layers are etched with traces and other features to create electrical connections for the electronic components. Vias are formed through the non-conductive substrate layers to connect the electronic components mounted on one or both sides of the PCB substrate. Continuous operation of high-power components mounted on PCB substrates with high-current density signals or fast-switching power supplies generate substantial quantities of thermal energy to dissipate. A variety of systems are implemented in the prior art to cool such systems, including various air and liquid-cooled systems.

Liquid-cooled systems have general advantages of higher thermal efficiency and overall capacity for thermal transfer within a given physical space, but this generally comes at the expense of increased complexity as the liquid coolant is isolated from the electronic components of the PCB to be cooled. As a result, cold plates, heat pipes, and other intermediate thermal transfer structures are used to bridge between heat-generating electronic components and liquid coolant within liquid-cooled systems. Such cold plates, heat pipes, and other intermediate thermal transfer structures are often fixed to the electronic components to be cooled through appropriate retention mechanisms, further complicating the overall design layout within modular computing systems that emphasize serviceability without requiring a full shutdown (e.g., servers within a data center).

The presently disclosed thermal interconnect provides for maintaining the integrity of a liquid coolant loop, while also providing for electronic component replacements within an overall system, while further maintaining a high level of thermal conductivity across the thermal interconnect. Hot-swappable electronic components may be incompatible with traditional cold plates as additional operations are required to detach the hot-swappable electronic components. Further, such activities risk a coolant leak and thus tend to require an entire associated system to be powered down for the component replacement. This is inefficient and undesirable as it causes unnecessary downtime for the entire system. The presently disclosed thermal interconnect allows for such replacements with little to no risk of coolant leaks, and thus no requirement to power down the entire system to replace a singular associated electronic component. Still further, the presently disclosed thermal interconnect may allow for more electronic components to be connected to a main cooling loop within the overall system, thereby yielding server architectures with increased density and higher processing power.

In various implementations, the presently disclosed thermal interconnect incorporates on one side a fixed flow distribution channel that provides cooling to places where it is impossible or impractical to extend the main cooling loop. Additionally, on the other side of the interconnect is a series of vapor chambers that are attached to one or more heat-generating electronic components. The thermal interconnect is a selectively connectable fixture that mates a series of alternating parallel structures, such as pins, together. The thermal interconnect further may include a series of spaced fluid cavities within some or all of the parallel structures. Thermal energy captured by the vapor chamber(s) is rejected into the liquid coolant via the thermal interconnect without requiring flexible hoses, which is a potential point of failure and coolant leaks. The thermal interconnect is compact but maximizes thermally conductive surface area within its fixture to maximize thermal transfer from the vapor chamber(s) to the main cooling loop.

The presently disclosed thermal interconnect may be used within a variety of systems, for example: hard disc drives, solid state drives, hybrid drives, computing device expansion modules (e.g., M.2 modules), field-programmable gate array (FPGA) cards, add-on printed circuit boards (PCBs), voltage regulators (VRs), network switches, dual in-line memory modules (DIMMs), and so on. Further, due to increasingly small clearances between components within a system (e.g., between heat-generating components and a shared cold plate or between a server chassis and difficult-to-reach places, such as a backplane for the server(s)), the presently disclosed thermal interconnect may be used in conjunction with a heat pipe to reach such difficult-to-reach places. This is technically advantageous in that it enables the presently disclosed thermal interconnect to be used to conduct thermal energy away from places that may otherwise be inaccessible.

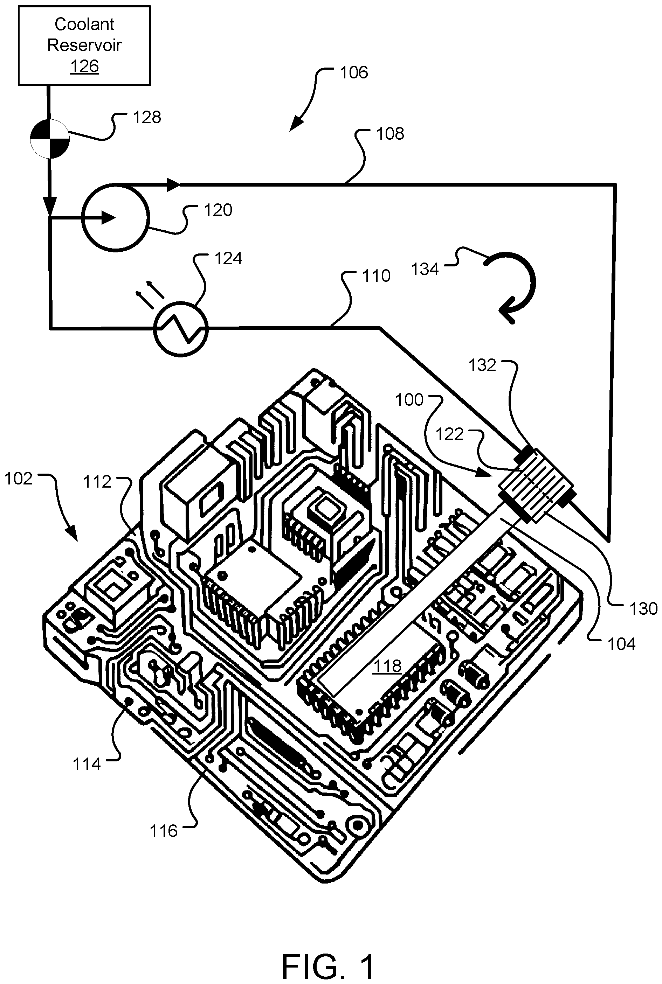

Accordingly, the presently disclosed technology is directed to thermal interconnects and associated cooling system technology for electronic systems, such as data storage systems, and associated electronic components, such as individual servers or data storage devices. Such technology may be useful in data centers as numerous heat-generating PCBs, and associated servers or data storage devices, may be present and a common liquid cooling system, such as external cooling system 106 of FIG. 1, discussed below, could circulate coolant from the PCBs using shared cooling system components, such as pumps, heat exchangers, and coolant reservoirs.

FIG. 1 illustrates a heat-generating component 118 mounted on a printed circuit board (PCB) 102 and cooled via a heat pipe 104 connected to an external cooling system 106 using an example thermal interconnect 100 according to the presently disclosed technology. The PCB 102 is thermally interconnected by virtue of the thermal interconnect 100. The PCB 102 includes an insulating substrate 112, such as a woven fiberglass cloth with an epoxy resin binder, with a network of conductive vias (e.g., via 114), traces (e.g., trace 116) and/or other conductive paths or areas thereon. The PCB 102 further includes a variety of electronic components (e.g., electronic component 118) soldered to the network of conductive paths thereon to create a functional electrical network interconnecting the electronic components mounted on one or both sides of the substrate 112, as well as through the substrate 112. In various implementations, conductive paths on different sides of the PCB 102 may be connected with the vias.

In various implementations, the electronic components may include capacitors, resistors, microprocessors, storage devices, etc. The PCB 102 may be single-sided (e.g., having one layer forming the conductive network), double-sided (e.g., having two conductive layers forming the conductive network,) or multi-layer (e.g., having inner and outer conductive layers forming the conductive network). Should the PCB 102 be double-sided or multi-layer, the electronic components may be soldered to the network of conductive paths on both sides, though only one side of one of the PCB 102 is illustrated in detail in FIG. 1. Various implementations described herein may be implemented on single-sided, double-sided, or multi-layer PCBs.

The number and arrangement of conductive traces, vias, planes, and other paths, as well as electronic components illustrated in FIG. 1 is an example only. Actual implementations of the presently disclosed technology may adopt nearly any possible arrangement of conductive traces, vias, planes, electronic components, and other components of a PCB. These conductive paths or areas are generally made of copper alloys (also referred to as simply copper herein), though other conductive materials are contemplated herein. Further, PCBs as referred to herein are defined as including any insulating substrate with a network of conductive paths formed thereon or therein. In various implementations, the PCB 102 may include ceramics, fiberglass, plastics (e.g., flexible polymers), or any combination thereof. For example, the PCB 102 may be flexible printed circuits ("FPCs") on a polyimide substrate.

The thermal interconnect 100 functions as a matched pair of thermal connectors 130, 132, which are conceptually illustrated in FIG. 1 as separated by dotted line 122. When connected, the thermal connectors 130, 132 create a thermally conductive connection between the heat pipe 104 and the external cooling system 106. The internal configuration of the thermal interconnect 100 yields a high thermal conductivity, as described in further detail below. The thermal connectors 130, 132 are removably attached to aid in the quick and easy connection of the PCB 102 to the external cooling system 106 and similar disconnection. This is a technical benefit as it improves the modular replaceability of the PCB 102, particularly when multiple similar PCBs are connected to the external cooling system 106 within a larger computing system (e.g., servers within a data center).

The heat pipe 104 is attached at one end to the heat-generating component 118 and extends away from the heat-generating component 118 to the thermal interconnect 100. In various implementations, the heat pipe 104 may be a vapor chamber (or planar heat pipe), a constant conductance heat pipe (CCHP), a variable conductance heat pipe (VCHP), a pressure-controlled heat pipe (PCHP), a diode heat pipe, a rotating heat pipe, a loop heat pipe, an oscillating or pulsating heat pipe, a thermosyphon, etc. The heat pipe 104 may be supplemented with internal structures to prevent the thermal interconnect 100 from interfering with the operation of the heat pipe 104 (e.g., internal columns or other features to direct thermal energy toward or away from the thermal interconnect 100 and avoid flooding the heat pipe 104). In implementations where space permits, the heat pipe 104 may be replaced with a heat exchanger, such as a heat sink or cold plate (e.g., carbon graphite or metallic structures intended to spread thermal energy). The various types of heat pipes, heat sinks, and cold plates are collectively referred to herein as heat-transfer devices. The heat pipe 104 terminates with the thermal connector 130.

The thermal connector 132 resides in line with the external cooling system 106 and is fed liquid coolant by supply 108 and outputs heated liquid coolant via return 110. The external cooling system 106 includes an external pump 120 that serves to circulate the coolant through the supply 108 and the return 110, as illustrated conceptually by arrow 134. An external heat exchanger 124 (e.g., liquid-to-air radiators, heat sinks, heat pipes, vapor chambers, etc.) may be provided in-line to remove thermal energy from the circulating coolant.

A coolant reservoir 126 may be provided within the external cooling system 106 to serve as a source of additional liquid coolant (e.g., to replace coolant in the event of a leak) and/or to serve as a buffer for the circulated liquid coolant. A valve 128 may control if, how, and when the coolant reservoir 126 is fluidly connected to the external cooling system 106. In some implementations, the coolant reservoir 126 may form part of the external heat exchanger 124 by diluting thermal energy into a much larger quantity of coolant as compared to the coolant contained within the supply 108 and the return 110 and connecting channels. In other implementations, the external cooling system 106 is a closed-loop with no coolant reservoir. The circulated liquid coolant may be any low-viscosity fluid that can effectively be circulated through the external cooling system 106 (e.g., water, ethylene glycol-based anti-freeze, light oils, etc.).

As an example, the electronic component 118 serves as a heat-generating component that is attached to the PCB 102 and is to be cooled by the heat pipe 104 and external cooling system 106. The heat pipe 104 is adhered or otherwise making thermally conductive contact with the electronic component 118 sufficient to effectively transfer thermal energy from the electronic component 118 to working fluid within the heat pipe 104. The heat pipe 104 uses a cyclical phase change of the working fluid to carry thermal energy from the electronic component 118 to the thermal interconnect 100. The thermal interconnect 100 transfers the thermal energy from the heat pipe 104 to the external cooling system 106. While the heat pipe 104 is thermally conductive with the electronic component 118, it is electrically isolated from the electronic component 118 and other electrical components of the PCB 102, including ground traces/planes, power traces/planes, and signal traces/planes, for example.

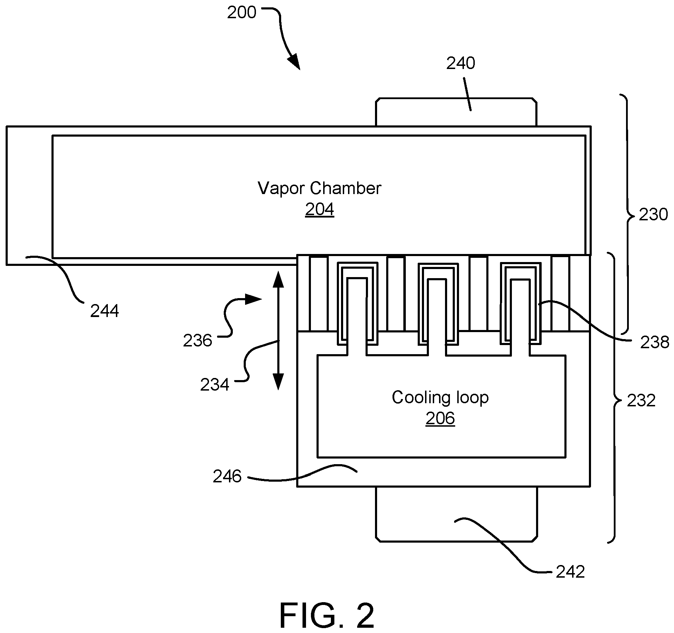

FIG. 2 illustrates an example thermal interconnect 200 according to the presently disclosed technology. The thermal interconnect 200 functions as a matched pair of thermal connectors 230, 232, which are interlaced by overlapping structures in interlaced region 236. The overlapping structures of the thermal connectors 230, 232 within the interlaced region 236 increases overall contact surface area between the thermal connectors 230, 232 as compared to prior art connectors. This is technically advantageous as increased contact surface area yields a lower resistance to thermal transmission across the thermal interconnect 200.

The overlapping structures may take a variety of forms, such as pins and corresponding receptacles, nested pins, pins and a corresponding flexible mesh, nested columns, slats, channels, etc. These structures may take any form or shape so long as they are linear in the direction of connection/disconnection of the thermal interconnect 200 (also referred to herein as linearly outward), as illustrated in arrow 234. Other implementations may adopt a non-linear connection approach. In some implementations, the overlapping structures may have a width or diameter dimension of less than 1mm, even when containing a cavity for fluid to fill.

The thermal interconnect 200 includes a thermal interface material 238 residing between the overlapping structures of the thermal connectors 230, 232. The thermal interconnect 200 may be considered a part of either or both of the thermal connectors 230, 232, or a separate structure (e.g., a gasket) or material (e.g., a conductive grease) altogether. Various other examples of the thermal interface material 238 include sliding thermal interface material (TIM), carbon sheets(s), etc. The thermal interface material 238 serves to improve thermal conductivity between the thermal connectors 230, 232 by closing gaps and/or providing increased thermal conductivity in areas of contact between the overlapping structures of the thermal connectors 230, 232. Other implementations may omit the thermal interface material 238 where thermal conductivity between the overlapping structures of the thermal connectors 230, 232 is deemed sufficient without the thermal interface material 238.

The thermal interconnect 200 includes retention structures 240, 242 that serve to hold the thermal connectors 230, 232, respectively, in place on adjacent structures (e.g., device chasses or PCBs). In various implementations, the retention structures 240, 242 include clips, clamps, push pins, straps, screws, etc. In some implementations, the retention structures 240, 242 may be used to selectively lock the thermal connectors 230, 232 together. This ensures the intended thermally conductive connection across the thermal interconnect 200 is maintained over time up until the retention structures 240, 242 are unlocked before separating the thermal connectors 230, 232. The retention structures 240, 242 may further serve to establish and maintain a compressive force between the retention structures 240, 242, which may aid thermal conductivity therebetween. Other implementations may omit one or both of the retention structures 240, 242 where the thermal interconnect 200 is sufficiently secured by the other of the retention structures 240, 242, the attached vapor chamber 204, and/or the attached cooling loop 206.

The thermal connectors 230, 232 are linearly brought together to connect the thermal interconnect 200 and linearly separated to disconnect the thermal interconnect 200, as illustrated by arrow 234. In some implementations, an additional rotation or linear sliding movement that is not along arrow 234 is used to lock the thermal connectors 230, 232 together and unlock the thermal connectors 230, 232 from one another (e.g., a twist-lock style connector). When connected, the thermal connectors 230, 232 create a thermally conductive connection between the vapor chamber 204 and the cooling loop 206 (both illustrated in part in FIG. 2). The internal configuration of the thermal interconnect 200 yields a high thermal conductivity, as described above. The thermal connectors 230, 232 are removably attached to aid in the quick and easy connection of a heat-generating component or structure (not shown, see e.g., electronic component 118 and PCB 102 of FIG. 1) to the cooling loop 206 and similar disconnection.

The vapor chamber 204 is attached at one end to the heat-generating component or structure and extends away from the heat-generating component or structure to the thermal interconnect 200. The vapor chamber 204 terminates with the thermal connector 230 and is filled with a phase-changing fluid, such as water. In this manner, the thermal connector 230 is in fluidic communication with the vapor chamber 204. The vapor chamber 204 is bounded by a thermally conductive body 244 made of stainless steel or copper or aluminum alloys, for example. The overlapping structures of the thermal connector 230 are contiguous extensions of the conductive body 244 and may or may not be hollow to allow the phase-changing fluid to enter the overlapping structures, in part depending on the size and shape of the overlapping structures. In various implementations, the vapor chamber 204 is replaced or supplemented with other heat-transfer device(s), such as heat pipe(s) or cold plate(s) with similar effect as described above.

The thermal connector 232 resides in line with the cooling loop 206, which forms part of an external cooling system, such as external cooling system 106 of FIG. 1. The cooling loop 206 is bounded by a thermally conductive body 246 made of stainless steel or copper or aluminum alloys, for example. The overlapping structures of the thermal connector 232 are contiguous extensions of the conductive body 246 and may or may not be hollow to allow coolant from the cooling loop 206 to enter the overlapping structures, in part depending on the size and shape of the overlapping structures. In various implementations, the cooling loop 206 is replaced or supplemented with other heat-transfer device(s), such as heat pipe(s) or cold plate(s) between the thermal connector 232 and the cooling loop 206 with similar effect as described above.

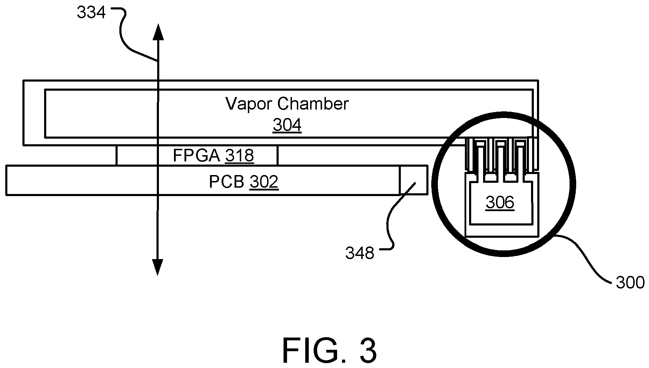

FIGs. 3-6 provide example use cases for the thermal interconnects described herein. While useful examples, the thermal interconnects described herein are not intended to be limited to the use cases of FIGs. 3-6.

FIG. 3 illustrates a field-programmable gate array (FPGA) 318 mounted on a PCB 302 and cooled via a vapor chamber 304 connected to a cooling loop 306 using an example thermal interconnect 300 according to the presently disclosed technology. The PCB 302 includes an insulating substrate, with a network of conductive paths or areas thereon. The PCB 302 further includes a variety of electronic components, such as FPGA 318, soldered to the network of conductive paths thereon to create a functional electrical network. The PCB 302 further includes an electrical connector 348 that allows the PCB 302 to be selectively electrically connected to a corresponding motherboard (not shown) by moving the PCB 302 linearly, as illustrated by arrow 334.

The thermal interconnect 300 functions as a matched pair of thermal connectors (see e.g., thermal connectors 230, 232 of FIG. 2). When connected, the thermal connectors create a thermally conductive connection between the vapor chamber 304 and the cooling loop 306, which is part of an external cooling system (not shown, see e.g., external cooling system 106 of FIG. 1). The internal configuration of the thermal interconnect 300 yields a high thermal conductivity by maximizing surface contact area between the thermal connectors. The thermal connectors are removably attached to aid in the quick and easy connection of the PCB 302 to the cooling loop 306 and similar disconnection.

The thermal connectors are linearly brought together to connect the thermal interconnect 300 and linearly separated to disconnect the thermal interconnect 300, as illustrated by arrow 334. As such, the electrical connection between the electrical connector 348 and the motherboard and the thermal connection at the thermal interconnect 300 are made simultaneously by movement of the PCB 302, FPGA 318, vapor chamber 304, and first thermal connector, as illustrated by the arrow 334, with reference to the motherboard and the second thermal connector, which are fixed in position. The described connection aids serviceability of an associated system in that it allows the PCB 302 and related components to be replaced without moving or otherwise directly accessing the cooling loop 306. The cooling loop 306 remains stationary and connected during the replacement.

The thermal connectors create a thermally conductive connection between the vapor chamber 304 and the cooling loop 306 at the thermal interconnect 300. The thermal connectors are removably attached to aid in the quick and easy connection of the FPGA 318, PCB 302, and associated structure(s) (if applicable) to the cooling loop 306 and similar disconnection.

The vapor chamber 304 is attached to the FPGA 318 and extends away from the FPGA 318 to the thermal interconnect 300. The vapor chamber 304 terminates with a thermal connector and is filled with a phase-changing fluid, such as water. In various implementations, the vapor chamber 304 is replaced or supplemented with another heat-transfer device, such as a heat pipe or a cold plate with similar effect. The thermal interconnect 300 further resides in line with the cooling loop 306, which forms part of an external cooling system, such as external cooling system 106 of FIG. 1. In various implementations, the cooling loop 306 is replaced or supplemented with another heat-transfer device, such as a heat pipe or a cold plate with similar effect as described above.

As an example, the FPGA 318 serves as a heat-generating component that is attached to the PCB 302 and is to be cooled by the vapor chamber 304 and cooling loop 306 forming part of the external cooling system. The vapor chamber 304 is adhered or otherwise making thermally conductive contact with the FPGA 318 sufficient to effectively transfer thermal energy from the FPGA 318 to working fluid with the vapor chamber 304. The vapor chamber 304 uses a cyclical phase change of the working fluid to carry thermal energy from the FPGA 318 to the thermal interconnect 300. The thermal interconnect 300 transfers the thermal energy from the vapor chamber 304 to the coolant within the cooling loop 306. While the vapor chamber 304 is thermally conductive with the FPGA 318, it is electrically isolated from the FPGA 318 and other electrical components of the PCB 302, including ground traces/planes, power traces/planes, and signal traces/planes, for example.

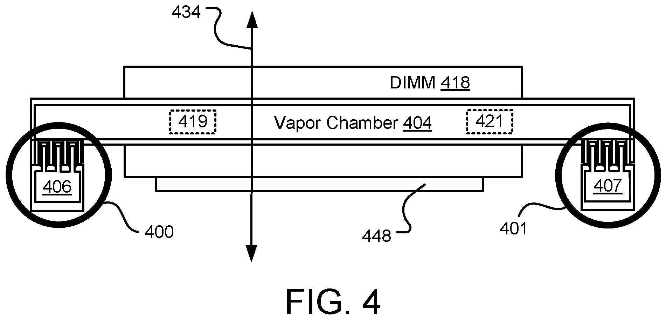

FIG. 4 illustrates a dual in-line memory module (DIMM) 418 cooled via a vapor chamber 404 connected to cooling loop sections 406, 407 using example thermal interconnects 400, 401 according to the presently disclosed technology. The DIMM 418 includes an insulating substrate, with a network of conductive paths or areas thereon. The DIMM 418 further includes a variety of heat-generating electronic components, such as heat-generating electronic components 419, 421, respectively, soldered to the network of conductive paths thereon to create a functional electrical network. The DIMM 418 further includes an electrical connector 448 that allows the DIMM 418 to be selectively electrically connected to a corresponding motherboard (not shown) by moving the DIMM 418 linearly, as illustrated by arrow 434.

The thermal interconnects 400, 401 each function as a matched pair of thermal connectors (see e.g., thermal connectors 230, 232 of FIG. 2). When connected, the thermal connectors create a thermally conductive connection between the vapor chamber 404 and the cooling loop sections 406, 407, which are part of an external cooling system (not shown, see e.g., external cooling system 106 of FIG. 1). The cooling loop sections 406, 407 may be oriented in-line or on distinct branches within the external cooling system. The internal configuration of the thermal interconnects 400, 401 yields a high thermal conductivity by maximizing surface contact area between the thermal connectors. The thermal connectors are removably attached to aid in the quick and easy connection of the DIMM 418 to the cooling loop sections 406, 407 and similar disconnection.

The thermal connectors are linearly brought together to connect the thermal interconnects 400, 401 and linearly separated to disconnect the thermal interconnects 400, 401, as illustrated by arrow 434. As such, the electrical connection between the electrical connector 448 and the motherboard and the thermal connections at the thermal interconnects 400, 401 are made simultaneously by downwardly directed movement of the DIMM 418, vapor chamber 304, and first thermal connectors, as illustrated by the arrow 434, with reference to the motherboard and the second thermal connectors, which are fixed in position. The described connection aids serviceability of an associated system in that it allows the DIMM 418 and related components to be replaced without moving or otherwise directly accessing the cooling loop. The cooling loop remains stationary and connected during the replacement.

The thermal connectors create a thermally conductive connection between the vapor chamber 404 and the cooling loop sections 406, 407 at the thermal interconnects 400, 401, respectively. The thermal connectors are removably attached to aid in the quick and easy connection of the DIMM 418 and associated structure (if applicable) to the cooling loop sections 406, 407 and similar disconnection.

The heat-generating electronic components 419, 421 lie between the insulating substrate for the DIMM 418 and the vapor chamber 404 and are thus illustrated in broken lines as they are hidden from view in FIG. 4. The vapor chamber 404 is attached to the heat-generating electronic components 419, 421 and extends away from the DIMM 418 to the thermal interconnects 400, 401. The vapor chamber 404 terminates at the thermal interconnects 400, 401 and is filled with a phase-changing fluid, such as water. In various implementations, the vapor chamber 404 is replaced or supplemented with another heat-transfer device, such as a heat pipe or a cold plate with similar effect. The thermal interconnects 400, 401 further reside in line with the cooling loop sections 406, 407, respectively, which forms part of the external cooling system, such as external cooling system 106 of FIG. 1. In various implementations, one or both of the cooling loop sections 406, 407 are replaced or supplemented with another heat-transfer device, such as a heat pipe or a cold plate with similar effect as described above.

As an example, the heat-generating electronic components 419, 421 are attached to the DIMM 418 and are to be cooled by the vapor chamber 404 and cooling loop sections 406, 407 forming part of the external cooling system. The vapor chamber 404 is adhered or otherwise making thermally conductive contact with the heat-generating electronic components 419, 421 sufficient to effectively transfer thermal energy from the heat-generating electronic components 419, 421 to working fluid with the vapor chamber 404. The vapor chamber 404 uses a cyclical phase change of the working fluid to carry thermal energy from the heat-generating electronic components 419, 421 to the thermal interconnects 400, 401. The thermal interconnects 400, 401 transfer the thermal energy from the vapor chamber 404 to the coolant within the cooling loop at cooling loop sections 406, 407, respectively. While the vapor chamber 404 is thermally conductive with the heat-generating electronic components 419, 421, it is electrically isolated from the DIMM 418, including ground traces/planes, power traces/planes, and signal traces/planes, for example.

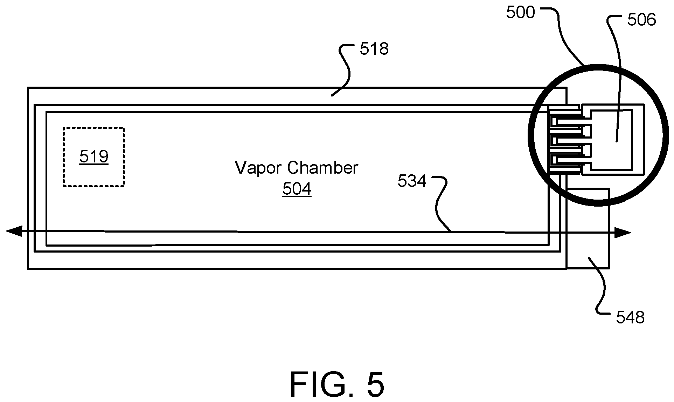

FIG. 5 illustrates a solid-state drive (SSD) 518 cooled via a vapor chamber 504 connected to a cooling loop 506 using an example thermal interconnect 500 according to the presently disclosed technology. The SSD 518 includes an insulating substrate, with a network of conductive paths or areas thereon. The SSD 518 further includes a variety of heat-generating electronic components, such as heat-generating electronic component(s) 519, soldered to the network of conductive paths thereon to create a functional electrical network. The heat-generating electronic component(s) 519 lie between the insulating substrate for the SSD 518 and the vapor chamber 504 and is thus illustrated in broken lines as it is hidden from view in FIG. 5. The SSD 518 further includes an electrical connector 548 that allows the SSD 518 to be selectively electrically connected to a corresponding motherboard (not shown) by moving the SSD 518 linearly, as illustrated by arrow 534.

The thermal interconnect 500 functions as a matched pair of thermal connectors (see e.g., thermal connectors 230, 232 of FIG. 2). When connected, the thermal connectors create a thermally conductive connection between the vapor chamber 504 and the cooling loop 506, which is part of an external cooling system (not shown, see e.g., external cooling system 106 of FIG. 1). The internal configuration of the thermal interconnect 500 yields a high thermal conductivity by maximizing surface contact area between the thermal connectors. The thermal connectors are removably attached to aid in the quick and easy connection of the SSD 518 to the cooling loop 506 and similar disconnection.

The thermal connectors are linearly brought together to connect the thermal interconnect 500 and linearly separated to disconnect the thermal interconnect 500, as illustrated by arrow 534. As such, the electrical connection between the electrical connector 548 and the motherboard and the thermal connection at the thermal interconnect 500 are made simultaneously by movement of the SSD 518, vapor chamber 504, and first thermal connector, as illustrated by the arrow 534, with reference to the motherboard and the second thermal connector, which are fixed in position. The described connection aids serviceability of an associated system in that it allows the SSD 518 and related components to be replaced without moving or otherwise directly accessing the cooling loop 506. The cooling loop 506 remains stationary and connected during the replacement.

The thermal connectors create a thermally conductive connection between the vapor chamber 504 and the cooling loop 506 at the thermal interconnect 500. The thermal connectors are removably attached to aid in the quick and easy connection of the SSD 518 and associated structure (if applicable) to the cooling loop 506 and similar disconnection.

The vapor chamber 504 is attached to the heat-generating electronic component(s) 519 and extends away from the SSD 518 to the thermal interconnect 500. The vapor chamber 504 terminates with a thermal connector and is filled with a phase-changing fluid, such as water. In various implementations, the vapor chamber 504 is replaced or supplemented with another heat-transfer device, such as a heat pipe or a cold plate with similar effect. The thermal interconnect 500 further resides in line with the cooling loop 506, which forms part of an external cooling system, such as external cooling system 106 of FIG. 1. In various implementations, the cooling loop 506 is replaced or supplemented with another heat-transfer device, such as a heat pipe or a cold plate with similar effect as described above.

As an example, the heat-generating electronic component(s) 519 is to be cooled by the vapor chamber 504 and the cooling loop 506 forming part of the external cooling system. The vapor chamber 504 is adhered or otherwise making thermally conductive contact with the heat-generating electronic component(s) 519 sufficient to effectively transfer thermal energy from the SSD 518 to working fluid with the vapor chamber 504. The vapor chamber 504 uses a cyclical phase change of the working fluid to carry thermal energy from the SSD 518 to the thermal interconnect 500. The thermal interconnect 500 transfers the thermal energy from the vapor chamber 504 to the coolant within the cooling loop 506. While the vapor chamber 504 is thermally conductive with the heat-generating electronic component(s) 519, it is electrically isolated from the SSD 518 and related electrical components, including ground traces/planes, power traces / planes, and signal traces/planes, for example.

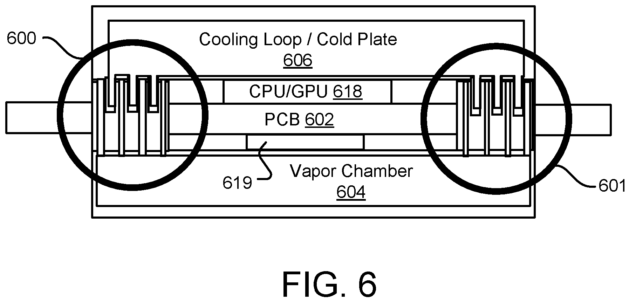

FIG. 6 illustrates heat-generating components 618, 619 mounted on opposing sides of a PCB 602 and cooled via a vapor chamber 604 and a cooling loop / cold plate 606 connected across the PCB 602 using example thermal interconnects 600, 601 according to the presently disclosed technology. The PCB 602 includes an insulating substrate, with a network of conductive paths or areas thereon. The PCB 602 further includes a variety of heat-generating electronic components, such as central processing unit (CPU) or graphical processing unit (GPU) 618 and voltage regulators (VRs) 619, soldered to the network of conductive paths thereon to create a functional electrical network. The PCB 602 may further include an electrical connector (not shown, see e.g., electrical connector 348 of FIG. 3) that allows the PCB 602 to be selectively electrically connected to a corresponding motherboard (not shown).

The thermal interconnects 600, 601 each function as a matched pair of thermal connectors (see e.g., thermal connectors 230, 232 of FIG. 2). When connected, the thermal connectors create a thermally conductive connection between the vapor chamber 604 and the cooling loop / cold plate 606, which is part of an external cooling system (not shown, see e.g., external cooling system 106 of FIG. 1). The cooling loop / cold plate 606 may be oriented in-line or on distinct branches within the external cooling system. The internal configuration of the thermal interconnects 600, 601 yields a high thermal conductivity by maximizing surface contact area between the thermal connectors. The thermal connectors are removably attached to aid in the quick and easy connection of the vapor chamber 604 to the cooling loop / cold plate 606 and similar disconnection.

The vapor chamber 604 is attached to the VRs 619 and extends away from the VRs 619 to the thermal interconnects 600, 601, which pass through apertures in the PCB 602. The vapor chamber 604 terminates at the thermal interconnects 600, 601 and is filled with a phase-changing fluid, such as water. The cooling loop / cold plate 606 is attached to the CPU/GPU 618 and extends away from the CPU/GPU 618 to the thermal interconnects 600, 601. The cooling loop / cold plate 606 includes the cold plate to conduct thermal energy away from the heat-generating electronic component 618 and the cooling loop to carry the thermal energy away from the PCB 602. The thermal interconnects 600, 601 reside in line with the cooling loop / cold plate 606, which forms part of the external cooling system, such as external cooling system 106 of FIG. 1. In various implementations, one or both of the vapor chamber 604 and the cooling loop / cold plate 606 are replaced or supplemented with another heat-transfer device with similar effect as described above.

As an example, the CPU/GPU 618 and VRs 619 are heat-generating components attached to opposite sides of the PCB 602 and are to be cooled by the vapor chamber 604 and the cooling loop / cold plate 606 forming part of the external cooling system. The vapor chamber 604 is adhered or otherwise making thermally conductive contact with the VRs 619 sufficient to effectively transfer thermal energy from the VRs 619 to working fluid with the vapor chamber 604. The vapor chamber 604 uses a cyclical phase change of the working fluid to carry thermal energy from the VRs 619 to the thermal interconnects 600, 601. In addition, a portion of the cooling loop / cold plate 606 is adhered or otherwise making thermally conductive contact with the CPU/GPU 618 sufficient to effectively transfer thermal energy from the CPU/GPU 618 to coolant with the cooling loop / cold plate 606.

The thermal interconnects 600, 601 transfer the thermal energy from the vapor chamber 604 to the coolant within the cooling loop / cold plate 606, as the coolant carries thermal energy away from the PCB 602 and into the external cooling system, such as external cooling system 106 of FIG. 1. While the vapor chamber 604 and the cooling loop / cold plate 606 are thermally conductive with components of the PCB 602, they are electrically isolated from the PCB 602 and electrical components of the PCB 602, including ground traces/planes, power traces / planes, and signal traces/planes, for example.

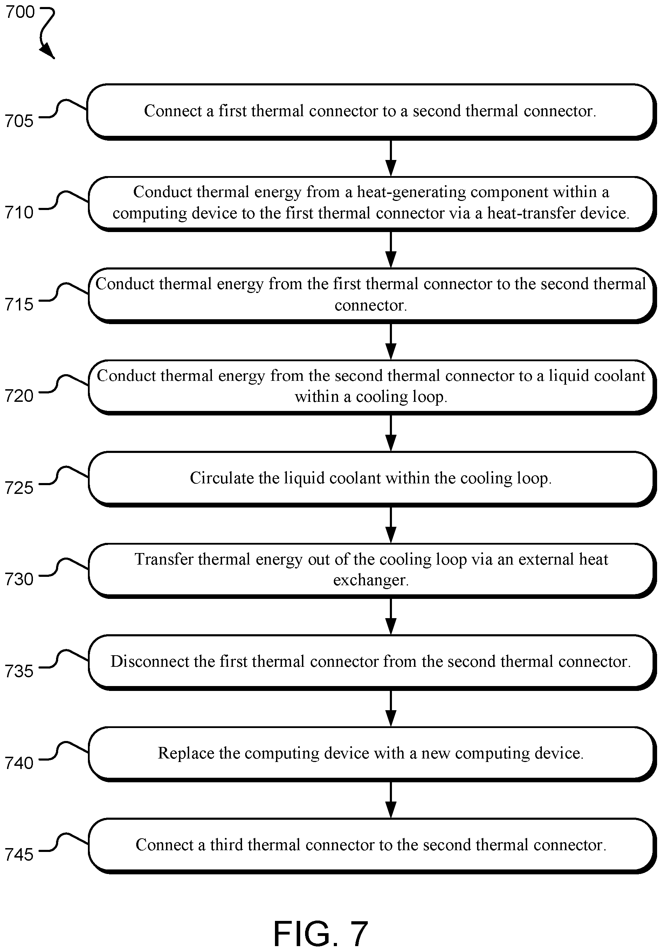

FIG. 7 illustrates example operations 700 for using a thermal interconnect to reject thermal energy from a computing device. The thermal interconnect comes in two connectable parts, a first thermal connector to a second thermal connector. The first thermal connector includes a first array of spaced structures extending linearly outward in parallel. In some implementations, the first array of spaced structures includes fluid cavities therein. The first thermal connector is contiguous with a heat-transfer device and the heat-transfer device is in thermally conductive contact with a heat-generating component of the computing device. The second thermal connector includes a second array of spaced structures also extending linearly outward in parallel and including fluid cavities therein. The second thermal connector is in fluidic communication with a cooling loop including a liquid coolant that may fill the fluid cavities in the second array of spaced structures.

A first connecting operation 705 connects the first thermal connector to the second thermal connector. This is accomplished by interlacing the first array of spaced structures with the second array of spaced structures. In various implementations, this also involves bringing the thermal connectors together to connect the thermal interconnect. As such, an electrical connection (e.g., at an electrical connector, discussed above) and the thermal connection at the thermal interconnect may be made simultaneously by movement of the first thermal connector and associated components with reference to the second thermal connector and associated components that are fixed in position. The described connection aids serviceability of an associated system in that it allows the first thermal connector and related components to be replaced without moving or otherwise directly accessing the cooling loop. The cooling loop remains stationary and connected during the replacement.

A first conducting operation 710 conducts thermal energy from the heat-generating component within the computing device to the first thermal connector via the heat-transfer device. A second conducting operation 715 conducts thermal energy from the first thermal connector to the second thermal connector. A third conducting operation 720 conducts thermal energy from the second thermal connector to the liquid coolant within the cooling loop. A circulating operation 725 circulates the liquid coolant within the cooling loop. The circulating operation 725 may be accomplished using a pump and a closed or open loop for the liquid coolant to move through. A transferring operation 730 transfers thermal energy out of the cooling loop via an external heat exchanger. The sum of conducting operations 710, 715, 720, circulating operation 725, and transferring operation 730 rejects the thermal energy from the computing device and out of an associated cooling system.

A disconnecting operation 735 disconnects the first thermal connector from the second thermal connector by separating the first array of spaced structures from the second array of spaced structures. In various implementations, this also involves separating the thermal connectors. As such, the electrical connection (e.g., at an electrical connector, discussed above) and the thermal connection at the thermal interconnect may be disconnected simultaneously by movement of the first thermal connector and associated components with reference to the second thermal connector and associated components that are fixed in position. The disconnecting operation 735 may be performed when the computing device fails or otherwise requires replacement.

A replacing operation 740 replaces the computing device with a new computing device. The new computing device includes a third thermal connector including a third array of spaced structures extending linearly outward in parallel. In some implementations, the third array of spaced structures includes fluid cavities therein. The third thermal connector is contiguous with a heat-transfer device and the heat-transfer device is in thermally conductive contact with a heat-generating component of the new computing device. A second connecting operation 745 connects the third thermal connector to the second thermal connector. This is accomplished by interlacing the third array of spaced structures with the second array of spaced structures. In various implementations, this also involves bringing the thermal connectors together to connect the thermal interconnect, as discussed in detail above.

The method or operations making up the embodiments of the invention described herein are referred to variously as operations, steps, objects, or modules. The operations may be performed in any order, adding or omitting operations as desired, unless explicitly claimed otherwise or a specific order is inherently necessitated by the claim language.

Hot-swappable electronic components may be incompatible with traditional cold plates as additional operations are required to detach the hot-swappable electronic components. Such activities risk a coolant leak and thus tend to require an entire associated system to be powered down for component replacement. This is inefficient and undesirable as it causes unnecessary downtime. The presently disclosed thermal interconnect allows for such replacements with little to no risk of coolant leaks, and thus no requirement to power down the entire system. Still further, the presently disclosed thermal interconnect may allow for more electronic components to be connected to a main cooling loop within the overall system, thereby yielding server architectures with increased density and higher processing power. The thermal interconnect is a selectively connectable fixture that mates a series of alternating parallel structures together. Thermal energy captured by the vapor chamber(s) is rejected into the liquid coolant via the thermal interconnect.

The presently disclosed technology includes a thermal interconnect comprising a first thermal connector and a second thermal connector. The first thermal connector includes a first array of spaced structures extending linearly outward in parallel, the first thermal connector contiguous with a heat-transfer device, the heat-transfer device in thermally conductive contact with a heat-generating component. The second thermal connector includes a second array of spaced structures extending linearly outward in parallel, the second array of spaced structures including fluid cavities therein, the second thermal connector in fluidic communication with a cooling loop including a liquid coolant. The second thermal connector is to selectively connect to the first thermal connector by interlacing the first array of spaced structures with the second array of spaced structures.

The heat-transfer device may be one of a heat pipe or a cold plate.

The heat-transfer device may be a heat pipe and the first array of spaced structures includes fluid cavities therein.

The first array of spaced structures may be a contiguous extension of a thermally conductive body of the heat-transfer device.

The first array of spaced structures and the second array of spaced fluid cavities may include one or more of pins, receptacles, columns, and slats.

The heat-generating component may be an electronic component mounted on a printed circuit board (PCB).

The heat-generating component may include one of hard disc drives, solid state drives, hybrid drives, computing device expansion modules, field-programmable gate array (FPGA) cards, add-on printed circuit boards (PCBs), voltage regulators, network switches, dual in-line memory modules, or components thereof.

The thermal interconnect may further comprise one or more retention structures to attach one or both of the first and the second thermal connectors to an adjacent structure.

The thermal interconnect may further comprise a pair of retention structures to selectively lock the first and the second thermal connectors together.

The thermal interconnect may further comprise a thermal interface residing between the first and the second thermal connectors.

The second thermal connector may selectively disconnect from the first thermal connector by separating the first array of spaced structures from the second array of spaced structures.

The presently disclosed technology further includes a method of using a thermal interconnect to reject thermal energy from a computing device comprising connecting a first thermal connector to a second thermal connector. The first thermal connector includes a first array of spaced structures extending linearly outward in parallel, the first thermal connector contiguous with a heat-transfer device, the heat-transfer device in thermally conductive contact with a heat-generating component of the computing device. The second thermal connector includes a second array of spaced structures extending linearly outward in parallel, the second array of spaced structures including fluid cavities therein, the second thermal connector in fluidic communication with a cooling loop including a liquid coolant, the connecting accomplished by interlacing the first array of spaced structures with the second array of spaced structures. The method further comprises conducting thermal energy from the heat-generating component within the computing device to the first thermal connector via the heat-transfer device, conducting thermal energy from the first thermal connector to the second thermal connector, and conducting thermal energy from the second thermal connector to the liquid coolant within the cooling loop thereby rejecting the thermal energy from the computing device to the liquid coolant.

The method may further comprise disconnecting the first thermal connector from the second thermal connector by separating the first array of spaced structures from the second array of spaced structures; replacing the computing device with a new computing device with a third thermal connector including a third array of spaced structures extending linearly outward in parallel, the third thermal connector contiguous with another heat-transfer device in thermally conductive contact with a heat-generating component of the new computing device; and connecting the third thermal connector to the second thermal connector by interlacing the third array of spaced structures with the second array of spaced structures.

The method may further comprise circulating the liquid coolant within the cooling loop and transferring thermal energy out of the cooling loop via an external heat exchanger.

The heat-transfer device may be one of a heat pipe or a cold plate.

The heat-transfer device may be a heat pipe and the first array of spaced structures may include fluid cavities therein.

The first array of spaced structures may be a contiguous extension of a thermally conductive body of the heat-transfer device.

The presently disclosed technology further includes a thermally interconnected printed circuit board (PCB) comprising a heat-generating component mounted to a substrate of the PCB; a vapor chamber in thermally conductive contact with the heat-generating component; and a first thermal connector including a first array of spaced structures extending linearly outward in parallel, the first thermal connector contiguous with the vapor chamber.

The first array of spaced structures may include fluid cavities therein.

The thermally interconnected PCB may further comprise a second thermal connector including a second array of spaced structures extending linearly outward in parallel, the second array of spaced structures including fluid cavities therein, the second thermal connector in fluidic communication with a cooling loop including a liquid coolant. The second thermal connector to selectively connect to the first thermal connector by interlacing the first array of spaced structures with the second array of spaced structures.

The above specification, examples, and data provide a complete description of the structure and use of exemplary embodiments of the invention. Since many embodiments of the invention can be made without departing from the spirit and scope of the invention, the invention resides in the claims hereinafter appended. Furthermore, structural features of the different embodiments may be combined in yet another embodiment without departing from the recited claims.

## Claims

1. A thermal interconnect (500) (300) (200) (100) comprising:
a first thermal connector (230) (130) including a first array of spaced structures extending linearly outward in parallel, the first thermal connector contiguous with a heat-transfer device (204) (104), the heat-transfer device in thermally conductive contact with a heat-generating component (118); and
a second thermal connector (232) (132) including a second array of spaced structures extending linearly outward in parallel, the second array of spaced structures including fluid cavities therein, the second thermal connector in fluidic communication with a cooling loop (206) (106) including a liquid coolant, wherein the second thermal connector is to selectively connect to the first thermal connector by interlacing the first array of spaced structures with the second array of spaced structures.

2. The thermal interconnect of claim 1, wherein:
the first array of spaced structures is a contiguous extension of a thermally conductive body of the heat-transfer device; or
the first array of spaced structures and the second array of spaced fluid cavities includes one or more of pins, receptacles, columns, and slats.

3. The thermal interconnect of claim 1, wherein:
the heat-generating component is an electronic component mounted on a printed circuit board (PCB); or
the heat-generating component includes one of hard disc drives, solid state drives, hybrid drives, computing device expansion modules, field-programmable gate array (FPGA) cards, add-on printed circuit boards (PCBs), voltage regulators, network switches, dual in-line memory modules, or components thereof.

4. The thermal interconnect of claim 1, further comprising:
one or more retention structures to attach one or both of the first and the second thermal connectors to an adjacent structure; or
a pair of retention structures to selectively lock the first and the second thermal connectors together.

5. The thermal interconnect of claim 1, further comprising:
a thermal interface residing between the first and the second thermal connectors.

6. The thermal interconnect of claim 1, wherein the second thermal connector is to selectively disconnect from the first thermal connector by separating the first array of spaced structures from the second array of spaced structures.

7. A method of using a thermal interconnect to reject thermal energy from a computing device (700) comprising:
connecting a first thermal connector to a second thermal connector (705),
the first thermal connector including a first array of spaced structures extending linearly outward in parallel, the first thermal connector contiguous with a heat-transfer device, the heat-transfer device in thermally conductive contact with a heat-generating component of the computing device,
the second thermal connector including a second array of spaced structures extending linearly outward in parallel, the second array of spaced structures including fluid cavities therein, the second thermal connector in fluidic communication with a cooling loop including a liquid coolant, the connecting accomplished by interlacing the first array of spaced structures with the second array of spaced structures;
conducting thermal energy from the heat-generating component within the computing device to the first thermal connector via the heat-transfer device (710);
conducting thermal energy from the first thermal connector to the second thermal connector (715); and
conducting thermal energy from the second thermal connector to the liquid coolant within the cooling loop thereby rejecting the thermal energy from the computing device to the liquid coolant (720).

8. The method of claim 7, further comprising:
disconnecting the first thermal connector from the second thermal connector by separating the first array of spaced structures from the second array of spaced structures;
replacing the computing device with a new computing device with a third thermal connector including a third array of spaced structures extending linearly outward in parallel, the third thermal connector contiguous with another heat-transfer device in thermally conductive contact with a heat-generating component of the new computing device; and
connecting the third thermal connector to the second thermal connector by interlacing the third array of spaced structures with the second array of spaced structures.

9. The method of claim 7, further comprising:
circulating the liquid coolant within the cooling loop; and
transferring thermal energy out of the cooling loop via an external heat exchanger.

10. The thermal interconnect of claim 1 or the method of claim 7, wherein the heat-transfer device is one of a heat pipe or a cold plate.

11. The thermal interconnect of claim 1 or the method of claim 7, wherein the heat-transfer device is a heat pipe, and wherein the first array of spaced structures include fluid cavities therein.

12. The method of claim 7, wherein the first array of spaced structures is a contiguous extension of a thermally conductive body of the heat-transfer device.

13. A thermally interconnected printed circuit board (PCB) (302) (102) comprising:
a heat-generating component (318) (118) mounted to a substrate (112) of the PCB;
a vapor chamber (304) (204) (104) in thermally conductive contact with the heat-generating component; and
a first thermal connector (230) (130) including a first array of spaced structures extending linearly outward in parallel, the first thermal connector contiguous with the vapor chamber.

14. The thermally interconnected PCB of claim 13, wherein the first array of spaced structures includes fluid cavities therein.

15. The thermally interconnected PCB of claim 13, further comprising:
a second thermal connector including a second array of spaced structures extending linearly outward in parallel, the second array of spaced structures including fluid cavities therein, the second thermal connector in fluidic communication with a cooling loop including a liquid coolant, wherein the second thermal connector is to selectively connect to the first thermal connector by interlacing the first array of spaced structures with the second array of spaced structures.
